# EUROPEAN PATENT APPLICATION

(11) **EP 4 535 403 A1**
(43) Date of publication of application: **09.04.2025**
(21) Application number: 23815913.1
(22) Date of filing: 25.05.2023
(51) Int. Cl.: H01L 21/304, C09J 183/04, C09J 183/07

(54) **PHOTORADIATION-RELEASABLE ADHESIVE COMPOSITION, LAMINATE, AND METHOD FOR PRODUCING PROCESSED SEMICONDUCTOR SUBSTRATE**

(30) Priority: 02.06.2022 JP 2022090199
(71) Applicant: Nissan Chemical Corporation, Tokyo 103-6119 (JP)
(72) Inventor: OKUNO, Takahisa, Toyama-shi, Toyama 939-2792 (JP); YANAI, Masaki, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2023/019427
(87) International publication number: WO 2023/234155

(57) **Abstract**

The present invention provides a laminate including an adhesive layer that has both a bonding function and a releasing function in a single layer and can be released through light irradiation, the laminate being capable of firmly bonding a support substrate to a semiconductor substrate during polishing of the semiconductor substrate and easily separating the support substrate from the semiconductor substrate through light irradiation after the polishing; an adhesive composition for forming such a releasable adhesive layer; and a method for producing a processed semiconductor substrate using the laminate. An adhesive composition for release by light irradiation for forming an adhesive layer of a laminate including a semiconductor substrate, a support substrate, and the adhesive layer provided between the semiconductor substrate and the support substrate, and the laminate being used for releasing the semiconductor substrate and the support substrate each other after the adhesive layer absorbs light emitted from a side of the support substrate, the adhesive composition including: an adhesive component (S); and a release agent component (R), wherein the adhesive component (S) contains a polysiloxane resin, and the release agent component (R) contains a (meth)acrylic polymer including a silicone-based first unit and a light-absorbing structured second unit.

## Description

### Technical Field

The present invention relates to an adhesive composition for release by light irradiation, a laminate, and a method for producing a processed semiconductor substrate.

### Background Art

In respect of a semiconductor wafer that has been integrated in a two-dimensional planar direction in the related art, there is a need for a semiconductor integration technique that integrates (laminates) planes in a three-dimensional direction for the purpose of further integration. This three-dimensional lamination is a technique of laminating layers into a multilayer while connecting the layers by a through-silicon via (TSV). At the time of multilayer integration, each of wafers to be integrated is thinned by polishing on a side opposite to the formed circuit surface (i.e. a rear surface), and the thinned semiconductor wafers are laminated.

In order to polish a semiconductor wafer before thinning (also simply referred to herein as a "wafer") with a polishing device, the semiconductor wafer is attached to a support. The adhesion at that time is referred to as "temporary adhesion" because it should be easily released after polishing. This temporary adhesion should be easily removed from the support, and the thinned semiconductor wafer may be cut or deformed when a large force is applied for removal. Thus, the semiconductor wafer is easily removed so that such a situation does not occur. However, at the time of polishing the rear surface of the semiconductor wafer, it is not preferable that the semiconductor wafer is detached or displaced due to polishing stress. Therefore, the performance required for the temporary adhesion is to withstand the stress during polishing and to be easily removed after polishing.

For example, there is a demand for performance having a high stress (strong adhesive force) in a planar direction at the time of polishing and a low stress (weak adhesive force) in a longitudinal direction at the time of removal.

Methods by laser irradiation have been disclosed for such adhesion and separation processes (see, for example, Patent Literatures 1 and 2). With recent further progress in the semiconductor field, new techniques related to release through irradiation with light such as a laser are always required.

### Citation List

### Patent Literature

Patent Literature 1: JP 2004-64040 A
Patent Literature 2: JP 2012-106486 A

### Summary of Invention

### Technical Problem

Patent Literatures 1 and 2 recite a laminate in which two layers: a bonding layer (adhesive layer) and a light-conversion layer (also referred to as "separation layer") containing a light-absorbing agent are laminated between a substrate and a support in order to release the substrate corresponding to the semiconductor wafer and the support by laser irradiation.

Incidentally, in a case where layers having both a bonding function of the adhesive layer and a releasing function of separating the support and the substrate of the separation layer from each other can be formed as one layer, a two-layer structure of the adhesive layer and the separation layer can be made a one-layer structure, and the number of layers can be reduced. Thus, this is desirable from the viewpoint of production of a laminate having a simpler structure.

Accordingly, it is desired to provide a laminate including an adhesive layer that has both a bonding function and a light-releasable function and can be released through light irradiation.

The present invention has been made in view of the above circumstances, and it is an object of the present invention to provide a laminate including an adhesive layer that has both a bonding function and a releasing function in a single layer and can be released through light irradiation, the laminate being capable of firmly bonding a support substrate to a semiconductor substrate during polishing of the semiconductor substrate and easily separating the support substrate from the semiconductor substrate through light irradiation after the polishing; an adhesive composition for forming such a releasable adhesive layer; and a method for producing a processed semiconductor substrate using the laminate.

### Solution to Problem

As a result of intensive studies to solve the above problem, the present inventors have found that the above problem can be solved, thereby completing the present invention having the following gist.

That is, the present invention includes the followings.
[1] An adhesive composition for release by light irradiation for forming an adhesive layer of a laminate including a semiconductor substrate, a support substrate, and the adhesive layer provided between the semiconductor substrate and the support substrate, and the laminate being used for releasing the semiconductor substrate and the support substrate each other after the adhesive layer absorbs light emitted from a side of the support substrate,
   the adhesive composition including: an adhesive component (S); and a release agent component (R), wherein
   the adhesive component (S) contains a polysiloxane resin, and
   the release agent component (R) contains a (meth)acrylic polymer including a silicone-based first unit and a light-absorbing structured second unit.
[2] The adhesive composition according to [1], wherein the silicone-based first unit is represented by any one of the following Formulae (A-1) and (A-2): 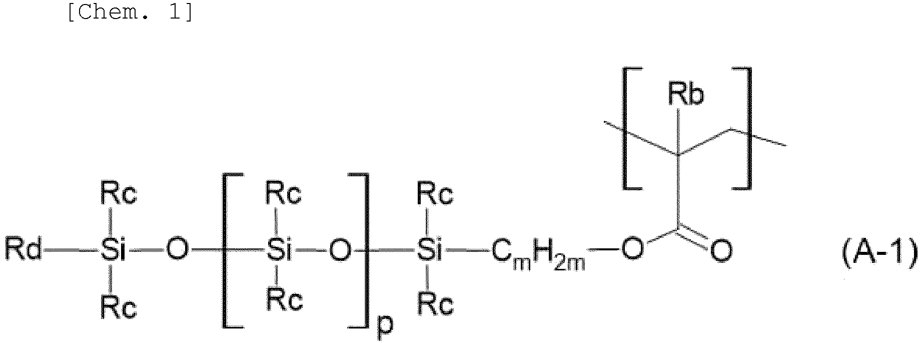 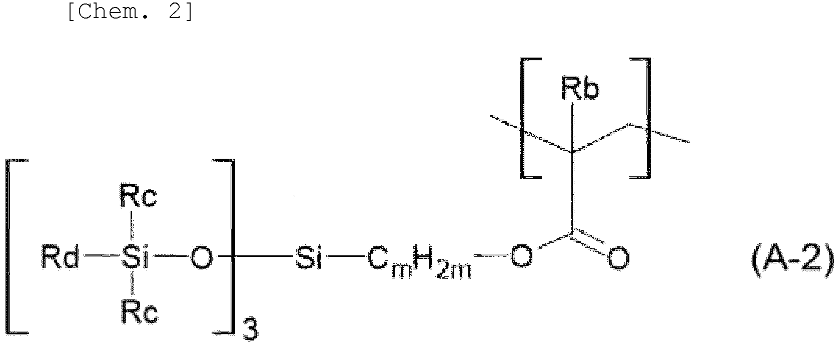 where in Formulae (A-1) and (A-2), Rb represents a hydrogen atom or a methyl group, Rc and Rd each independently represent a hydrogen atom, an alkyl group, or a phenyl group, and m and p each independently represent an integer of 0 or more.
[3] The adhesive composition according to [1], wherein the light-absorbing structured second unit has a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, a phenylbenzotriazole structure, an acenaphthene structure, and a cinnamic acid-derived structure.
[4] The adhesive composition according to [3], wherein the light-absorbing structured second unit has a structure represented by any one of the following Formulae (1) to (9) : 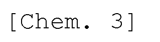 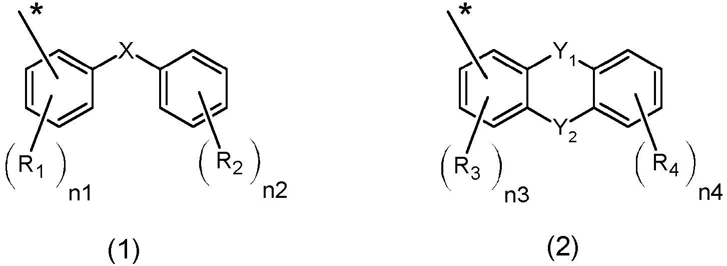 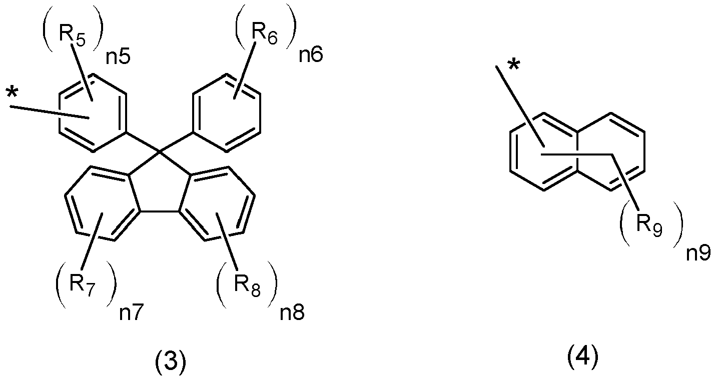 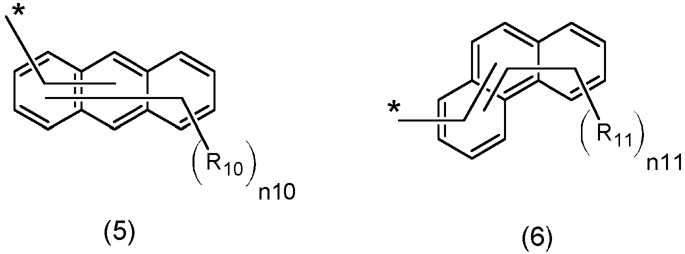 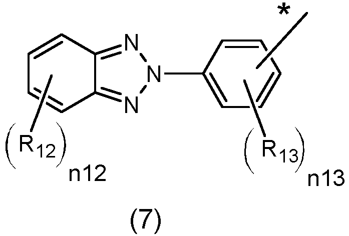 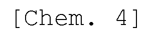 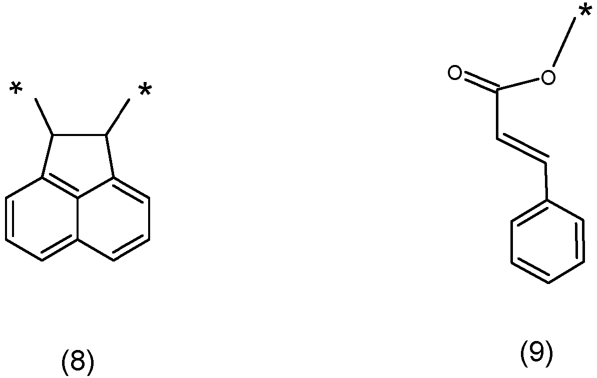
   where in Formulae (1) to (9), R₁ to R₁₃ each independently represent a halogen atom or a monovalent group,
   X represents a single bond, -O-, -CO-, -NR₃₁- (R₃₁ represents a hydrogen atom, an optionally substituted alkyl group, or an optionally substituted aryl group.), -SO-, - SO₂-, or -N=N-,
   Y₁ represents a single bond or -CO-, when Y₁ is a single bond, Y₂ represents -O-, -CO-, or -NR₃₂- (R₃₂ represents a hydrogen atom, an optionally substituted alkyl group, or an optionally substituted aryl group.), when Y₁ is -CO-, Y₂ represents -CO-,
   n1 is an integer of 0 to 4,
   n2 is an integer of 0 to 5,
   n3 is an integer of 0 to 3,
   n4 is an integer of 0 to 4,
   n5 is an integer of 0 to 4,
   n6 is an integer of 0 to 5,
   n7 is an integer of 0 to 4,
   n8 is an integer of 0 to 4,
   n9 is an integer of 0 to 7,
   n10 is an integer of 0 to 9,
   n11 is an integer of 0 to 9,
   n12 is an integer of 0 to 4,
   n13 is an integer of 0 to 4,
   each asterisk * represents a bonding hand, and
   when a plurality of R₁ to R₁₃ is present, each of the plurality of R₁ to R₁₃ may be identical to or different from one another.
[5] The adhesive composition according to [4], wherein the light-absorbing structured second unit is represented by any one of the following Formulae (B-1) to (B-5): 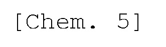 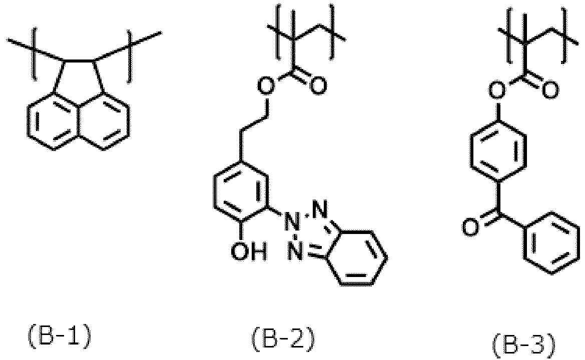 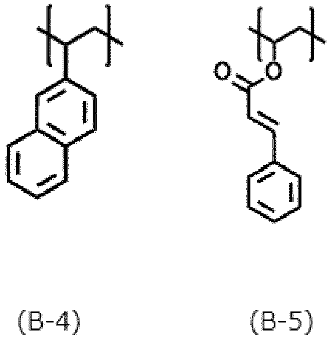
[6] The adhesive composition according to [1], wherein the polysiloxane resin contained in the adhesive component (S) contains a component (A) that is cured.
[7] The adhesive composition according to [6], wherein the component (A) that is cured is a component that is cured by a hydrosilylation reaction.
[8] The adhesive composition according to [7], wherein the component (A) that is cured contains:
   a polyorganosiloxane (a1) containing an alkenyl group having 2 to 40 carbon atoms bonded to a silicon atom;
   a polyorganosiloxane (a2) containing a Si-H group; and
   a platinum group metal-based catalyst (A2).
[9] The adhesive composition according to [1], wherein the (meth)acrylic polymer contained in the release agent component (R) further contains a third unit represented by the following Formula (C-1) or (C-2): 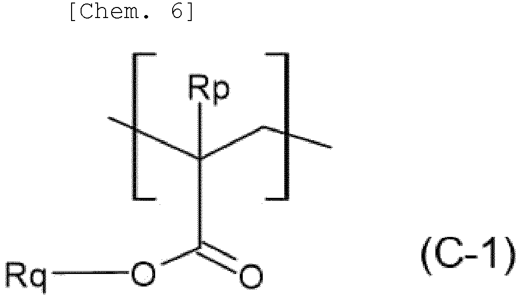 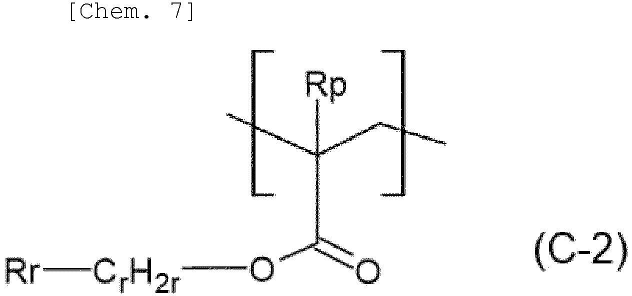 where in Formulae (C-1) and (C-2), Rp represents a hydrogen atom or a methyl group, Rq represents a chain saturated hydrocarbon group having 3 or more carbon atoms, Rr represents an aromatic hydrocarbon group or an aliphatic hydrocarbon group having 6 or more carbon atoms, and r represents an integer of 0 or more.
[10] The adhesive composition according to [9], wherein the third unit is represented by any one of the following Formulae (C-3) to (C-7): 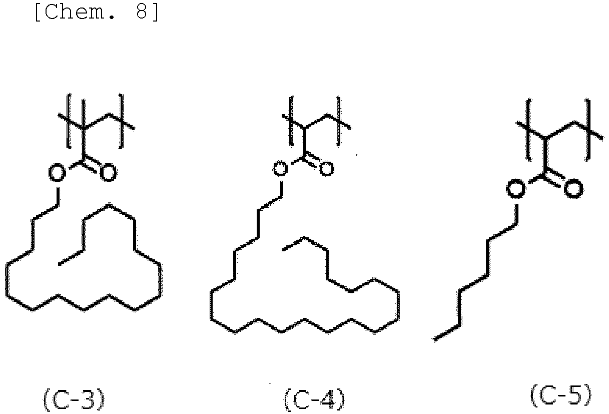 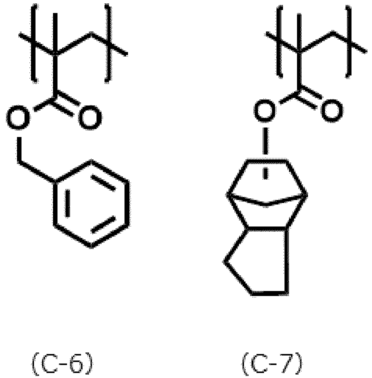
[11] A laminate including:
   a semiconductor substrate;
   a light-transmissive support substrate; and
   an adhesive layer provided between the semiconductor substrate and the support substrate,
   the laminate being used for releasing the semiconductor substrate and the support substrate each other after the adhesive layer absorbs light emitted from a side of the support substrate,
   wherein the adhesive layer is formed of the adhesive composition according to any one of [1] to [10].
[12] A method for producing a processed semiconductor substrate,
   the method including:
   a third step of processing the semiconductor substrate of the laminate according to [11]; and
   a fourth step of separating the semiconductor substrate, which has been processed in the third step, and the support substrate from each other.
[13] The method for producing a processed semiconductor substrate according to [12], wherein the fourth step includes a step of irradiating the laminate with a laser from a side of the support substrate.

### Advantageous Effects of Invention

According to the present invention, it is possible to provide a laminate including an adhesive layer that has both a bonding function and a releasing function in a single layer and can be released through light irradiation, the laminate being capable of firmly bonding a support substrate to a semiconductor substrate during polishing of the semiconductor substrate and easily separating the support substrate and the semiconductor substrate from each other through light irradiation after the polishing; an adhesive composition for forming such a releasable adhesive layer; and a method for producing a processed semiconductor substrate using the laminate.

### Brief Description of Drawings

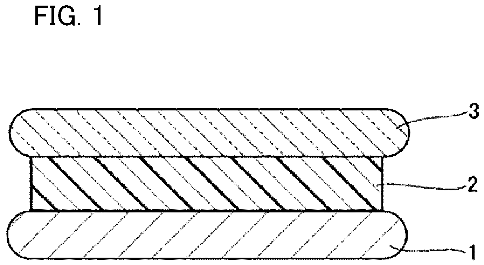

Fig. 1 is a schematic cross-sectional view of an example of a laminate.

### Description of Embodiments

### (Adhesive Composition for Release by Light Irradiation)

The adhesive composition of the present invention is an adhesive composition for release by light irradiation that can be released by light irradiation.

The adhesive composition of the present invention is a composition that can be suitably used for forming an adhesive layer for temporary adhesion to process a semiconductor substrate.

The adhesive composition of the present invention contains an adhesive component (S) and a release agent component (R).

In addition to the adhesive component (S) and the release agent component (R), the adhesive composition of the present invention may contain an additional component such as a solvent, for example, in order to adjust the viscosity and the like of the adhesive composition.

The adhesive composition of the present invention can be prepared by a simple method of only mixing the adhesive component (S) and the release agent component (R), and the adhesive composition can favorably form a light-releasable adhesive layer which effectively functions as both an adhesive layer for temporary adhesion and a laser-releasable agent layer as shown in Examples hereinbelow.

### <Adhesive Component (S)>

The adhesive component (S) according to the present invention contains a polysiloxane resin.

The polysiloxane resin contains, for example, a component (A) that is cured to be an adhesive component.

Examples of a preferred aspect of the component (A) that is cured include a component (A) that is cured by a hydrosilylation reaction, and examples of a more preferred aspect thereof includes a polyorganosiloxane component (A') that is cured by a hydrosilylation reaction.

In a more preferred aspect of the present invention, as an example of the component (A'), the component (A) contains, for example, a polyorganosiloxane (a1) having an alkenyl group having 2 to 40 carbon atoms bonded to a silicon atom, a polyorganosiloxane (a2) having a Si-H group, and a platinum group metal-based catalyst (A2). Here, the alkenyl group having 2 to 40 carbon atoms is optionally substituted. Examples of the substituent include a halogen atom, a nitro group, a cyano group, an amino group, a hydroxy group, a carboxyl group, an aryl group, and a heteroaryl group.

In another more preferred aspect of the present invention, the polyorganosiloxane component (A') that is cured by a hydrosilylation reaction contains a polysiloxane (A1) containing one or two or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}, and a platinum group metal-based catalyst (A2), and
the polysiloxane (A1) contains one or two or more units selected from the group consisting of a siloxane unit (Q' unit) represented by SiO₂, a siloxane unit (M' unit) represented by R¹'R²'R³'SiO_{1/2}, a siloxane unit (D' unit) represented by R⁴'R⁵'SiO_{2/2}, and a siloxane unit (T' unit) represented by R⁶'SiO_{3/2}, contains a polyorganosiloxane (a1') containing at least one selected from the group consisting of an M' unit, a D' unit, and a T' unit, and one or two or more units selected from the group consisting of a siloxane unit (Q" unit) represented by SiO₂, a siloxane unit (M" unit) represented by R¹"R²"R³"SiO_{1/2}, a siloxane unit (D" unit) represented by R⁴"R⁵"SiO_{2/2}, and a siloxane unit (T" unit) represented by R⁶"SiO_{3/2}, and contains a polyorganosiloxane (a2') containing at least one selected from the group consisting of an M" unit, a D" unit, and a T" unit.

Note that (a1') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹' to R⁶' are groups bonded to a silicon atom and each independently represent an optionally substituted alkyl group or an optionally substituted alkenyl group, and at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹" to R⁶" are groups or atoms bonded to a silicon atom and each independently represent an optionally substituted alkyl group or a hydrogen atom, and at least one of R¹" to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be a linear, branched, or cyclic alkyl group, but is preferably a linear or branched alkyl group. The number of carbon atoms thereof is not particularly limited, and is ordinarily 1 to 40, preferably 30 or less, more preferably 20 or less, and still more preferably 10 or less.

Specific examples of the linear or branched alkyl group which is optionally substituted, but are not limited to, include a methyl group, an ethyl group, an n-propyl group, an i-propyl group, an n-butyl group, an i-butyl group, an s-butyl group, a t-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group. The number of carbon atoms thereof is ordinarily 1 to 14, preferably 1 to 10, and more preferably 1 to 6. Among these groups, a methyl group is particularly preferred.

Specific examples of the cyclic alkyl group which is optionally substituted include, but are not limited to, cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group; cycloalkyl groups such as a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and bicycloalkyl groups such as a bicyclobutyl group, a bicyclopentyl group, a bicyclohexyl group, a bicycloheptyl group, a bicyclooctyl group, a bicyclononyl group, and a bicyclodecyl group. The number of carbon atoms thereof is ordinarily 3 to 14, preferably 4 to 10, and more preferably 5 or 6.

The alkenyl group may be a linear or branched alkenyl group, and the number of carbon atoms thereof is not particularly limited, and is ordinarily 2 to 40, preferably 30 or less, more preferably 20 or less, and still more preferably 10 or less.

Specific examples of the linear or branched alkenyl group which is optionally substituted include, but are not limited to, a vinyl group, an allyl group, a butenyl group, and a pentenyl group. The number of carbon atoms thereof is ordinarily 2 to 14, preferably 2 to 10, and more preferably 1 to 6. Among these groups, an ethenyl group and a 2-propenyl group are particularly preferred.

Specific examples of the cyclic alkenyl group which is optionally substituted include, but are not limited to, cyclopentenyl and cyclohexenyl. The number of carbon atoms thereof is ordinarily 4 to 14, preferably 5 to 10, and more preferably 5 or 6.

As described above, the polysiloxane (A1) contains a polyorganosiloxane (a1') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction with the platinum group metal-based catalyst (A2) and are cured. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more kinds of polyorganosiloxanes satisfying such conditions may be used in combination.

Examples of preferred combinations of two or more selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, in a case where two or more kinds of polyorganosiloxanes contained in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferred, but are not limited thereto.

The polyorganosiloxane (a2') contains one or two or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more kinds of polyorganosiloxanes satisfying such conditions may be used in combination.

Examples of preferred combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') is composed of siloxane units in which alkyl groups and/or alkenyl groups are bonded to silicon atoms thereof, and a ratio of alkenyl groups in all substituents represented by R¹' to R⁶' is preferably 0.1 to 50.0 mol%, more preferably 0.5 to 30.0 mol%, and the remaining R¹' to R⁶' can be alkyl groups.

The polyorganosiloxane (a2') is composed of siloxane units in which alkyl groups and/or hydrogen atoms are bonded to silicon atoms thereof, and a ratio of hydrogen atoms in all substituents and substitutional atoms represented by R¹" to R⁶" is preferably 0.1 to 50.0 mol%, more preferably 10.0 to 40.0 mol%, and the remaining R¹" to R⁶" can be alkyl groups.

In a case where the component (A) contains (a1) and (a2), in a preferred aspect of the present invention, a molar ratio of the alkenyl group contained in the polyorganosiloxane (a1) and the hydrogen atom constituting the Si-H bond contained in the polyorganosiloxane (a2) is in a range of 1.0 : 0.5 to 1.0 : 0.66.

The weight-average molecular weight of the polysiloxane such as the polyorganosiloxane (a1) or the polyorganosiloxane (a2) is not particularly limited, and is ordinarily 500 to 1,000,000, and is preferably 5,000 to 50,000 from the viewpoint of realizing the effects of the present invention with excellent reproducibility.

In the present invention, the weight-average molecular weight, number average molecular weight, and dispersity of the polyorganosiloxane (excluding the organosiloxane polymer described above) can be measured, for example, using a GPC apparatus (EcoSEC and HLC-8320GPC, manufactured by Tosoh Corporation) and a GPC column (TSKgel SuperMultiporeHZ-N and TSKgel SuperMultiporeHZ-H, manufactured by Tosoh Corporation) at a column temperature of 40°C, using tetrahydrofuran as an eluent (elution solvent), and using polystyrene (Shodex, manufactured by Showa Denko K.K.) as a standard sample at a flow rate of 0.35 mL/min.

The viscosity of each of the polyorganosiloxane (a1) and the polyorganosiloxane (a2) is not particularly limited, and is ordinarily 10 to 1,000,000 (mPa·s), and is preferably 50 to 200,000 (mPa·s) from the viewpoint of realizing the effects of the present invention with excellent reproducibility. The viscosity of each of the polyorganosiloxane (a1) and the polyorganosiloxane (a2) is a value measured at 25°C with an E-type rotational viscometer.

The polyorganosiloxane (a1) and the polyorganosiloxane (a2) react with each other by a hydrosilylation reaction to form a cured film. Therefore, the mechanism of curing is different from that via, for example, a silanol group. Thus, any siloxane does not need to contain a silanol group or a functional group that forms a silanol group by hydrolysis, such as an alkyloxy group.

In a preferred aspect of the present invention, the adhesive component (S) contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum black, platinum(II) chloride, chloroplatinic acid, a reaction product of chloroplatinic acid and monohydric alcohol, a complex of chloroplatinic acid and olefins, and platinum bisacetoacetate.

Examples of the complex of platinum and olefins include, but are not limited to, a complex of divinyltetramethyldisiloxane and platinum.

The amount of the platinum group metal-based catalyst (A2) is not particularly limited, and is ordinarily in a range of 1.0 to 50.0 ppm relative to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as it can suppress the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, and is ordinarily 1000.0 ppm or more relative to the total amount of the polyorganosiloxane (a1) and the polyorganosiloxane (a2) from the viewpoint of achieving the effect, and is 10,000.0 ppm or less from the viewpoint of preventing excessive suppression of the hydrosilylation reaction.

### <Release Agent Component (R)>

The release agent component (R) according to the present invention contains a (meth)acrylic polymer. The (meth)acrylic polymer includes a silicone-based first unit and a light-absorbing structured second unit.

The adhesive composition of the present invention prepared by using the polysiloxane resin of the adhesive component (S) described above and the (meth)acrylic polymer including the first unit and the second unit as the release agent component (R) in combination can favorably form a light-releasable adhesive layer which effectively functions as both an adhesive layer for temporary adhesion and a laser-releasable agent layer.

In addition to the first unit and the second unit, the (meth)acrylic polymer preferably includes a third unit in order to further enhance the compatibility between the first unit and the second unit.

Hereinafter, the units of the (meth)acrylic polymer will be described in detail.

The "(meth)acrylic polymer" refers to a methacrylic polymer and/or an acrylic polymer.

### <<First Unit>>

The (meth)acrylic polymer according to the present invention includes a silicone-based first unit.

In mixing the adhesive component (S) and the release agent component (R), the first unit is effective in enhancing the solubility in the adhesive component (S).

The silicone-based first unit is preferably a unit represented by any one of the following Formulae (A-1) and (A-2): 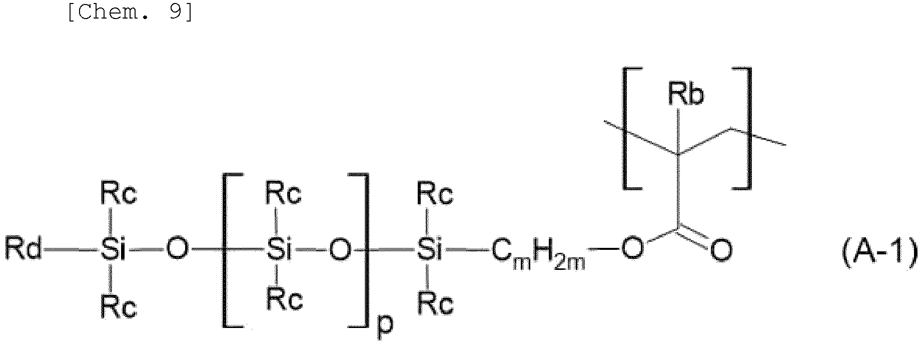 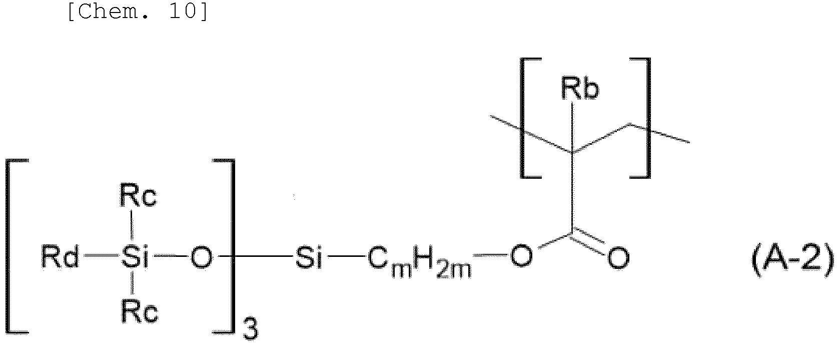 where in Formulae (A-1) and (A-2), Rb represents a hydrogen atom or a methyl group, Rc and Rd each independently represent a hydrogen atom, an alkyl group, or a phenyl group, and m and p each independently represent an integer of 0 or more.

Preferably, Rc is a methyl group.

Examples of the alkyl group of Rd include an alkyl group having 1 to 6 carbon atoms. Examples of the alkyl group having 1 to 6 carbon atoms include a methyl group, an ethyl group, and a butyl group.

m is, for example, 1 to 10, and is preferably 2 to 5.

The silicone-based first unit can be prepared, for example, by using a monomer represented by the following Formula (A-1-1) or (A-2-1) and polymerizing the monomer. Examples of the monomer represented by the following Formula (A-1-1) or (A-2-1) include X-22-174ASX, X-22-2426, X-22-2475, and KF-2012 (manufactured by Shin-Etsu Chemical Co., Ltd.), and FM-0711, FM-0721, and FM-0725 (manufactured by JNC Corporation).

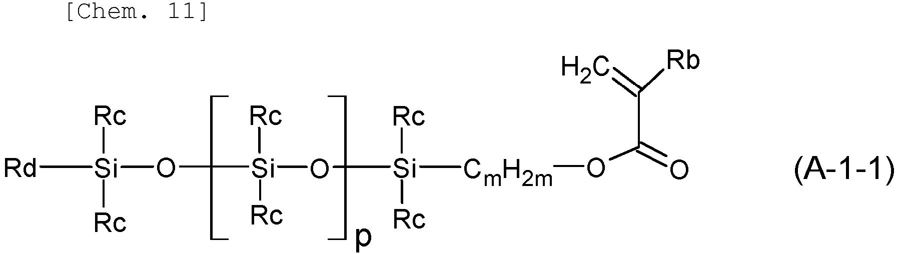

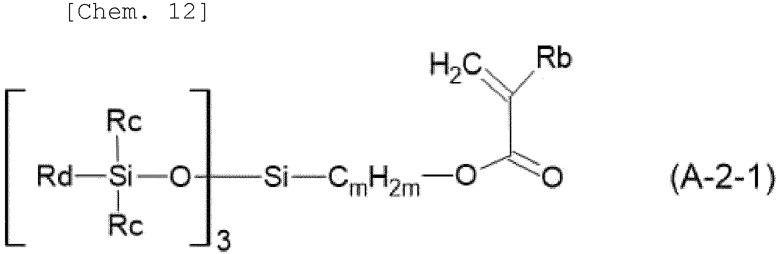

The reference numerals in Formulae (A-1-1) and (A-2-1) are the same as the reference numerals in Formulae (A-1) and (A-2) above.

### <<Second Unit>>

The (meth)acrylic polymer according to the present invention includes a light-absorbing structured second unit.

The second unit has a structure which absorbs light and contributes to easy release of the semiconductor substrate and the support substrate by absorbing the light.

The structure included in the second unit absorbs light to alter the adhesive layer. As a result, after the adhesive layer is irradiated with light, the semiconductor substrate and the support substrate are easily separated from each other.

From the viewpoint of realizing good releasability between the semiconductor substrate and the support substrate due to excellent light absorption, the light-absorbing structured second unit preferably has a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, a phenylbenzotriazole structure, an acenaphthene structure, and a cinnamic acid-derived structure.

The light-absorbing structure may have a substituent. Examples of the substituent in the light-absorbing structure include an alkyl group, an alkoxy group, an aryl group, a halogen atom, a hydroxy group, a nitro group, a cyano group, an amide group, a sulfonamide group, an imide group, a carboxy group, a carboxylic acid ester group, a sulfo group, a sulfonic acid ester group, an alkylamino group, and an arylamino group.

The light-absorbing structure is preferably a structure represented by any one of the following Formulae (1) to (9) from the viewpoint of realizing good releasability between the semiconductor substrate and the support substrate due to excellent light absorption. 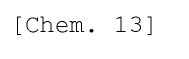 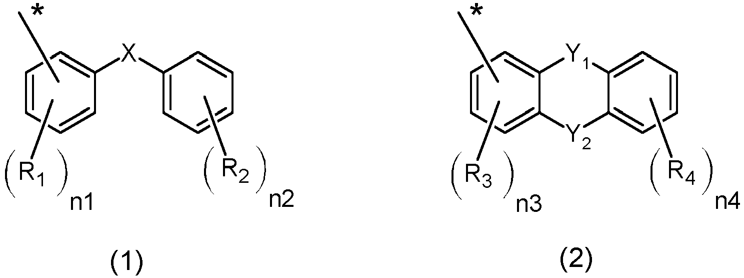 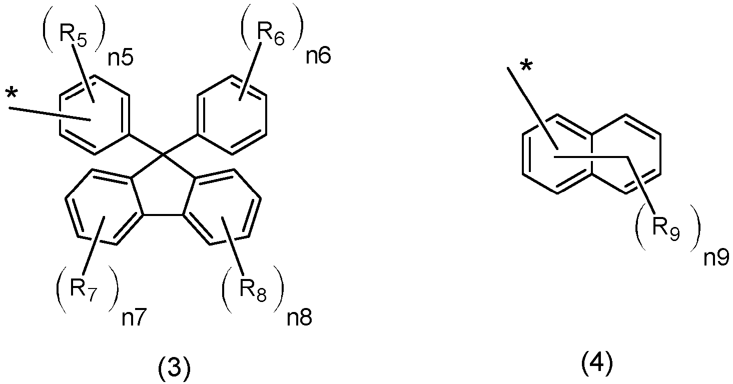 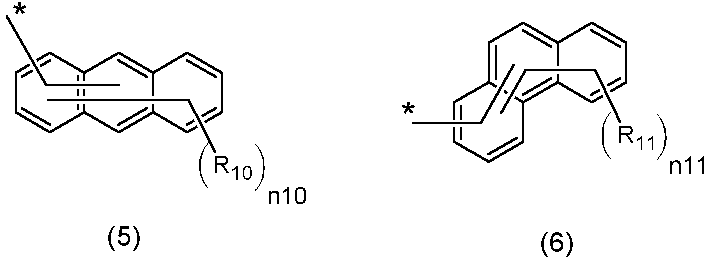 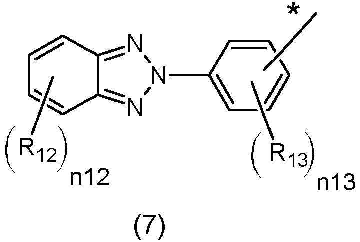 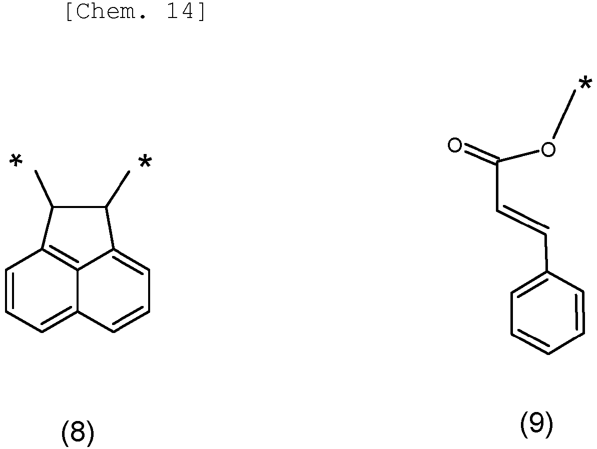
where in Formulae (1) to (7), R₁ to R₁₃ each independently represent a halogen atom or a monovalent group,
X represents a single bond, -O-, -CO-, -NR₃₁- (R₃₁ represents a hydrogen atom, an optionally substituted alkyl group, or an optionally substituted aryl group.), -SO-, - SO₂-, or -N=N-,
Y₁ represents a single bond or -CO-, when Y₁ is a single bond, Y₂ represents -O-, -CO-, or -NR₃₂- (R₃₂ represents a hydrogen atom, an optionally substituted alkyl group, or an optionally substituted aryl group.), when Y₁ is -CO-, Y₂ represents -CO-,
n1 is an integer of 0 to 4,
n2 is an integer of 0 to 5,
n3 is an integer of 0 to 3,
n4 is an integer of 0 to 4,
n5 is an integer of 0 to 4,
n6 is an integer of 0 to 5,
n7 is an integer of 0 to 4,
n8 is an integer of 0 to 4,
n9 is an integer of 0 to 7,
n10 is an integer of 0 to 9,
n11 is an integer of 0 to 9,
n12 is an integer of 0 to 4,
n13 is an integer of 0 to 4,
each asterisk * represents a bonding hand, and
when a plurality of R₁ to R₁₃ is present, each of the plurality of R₁ to R₁₃ may be identical to or different from one another.

Examples of the halogen atom in R₁ to R₁₃ include a fluorine atom, a chlorine atom, a bromine atom, and an iodine atom.

Examples of the monovalent group in R₁ to R₁₃ include an atomic group composed of two or more atoms, and specific examples thereof include an optionally substituted alkyl group, an optionally substituted alkoxy group, an optionally substituted aryl group, a hydroxy group, a nitro group, a cyano group, a carboxy group, a sulfo group, - N(R₂₁)(R₂₂) (R₂₁ and R₂₂ each independently represent a hydrogen atom, an optionally substituted alkyl group, or an optionally substituted aryl group).

Examples of the optionally substituted alkyl group in specific examples of R₁ to R₁₃ include an optionally substituted alkyl group having 1 to 20 carbon atoms. Examples of the substituent include a halogen atom, a hydroxy group, a carboxy group, and an alkoxy group.

Examples of the optionally substituted alkoxy group in specific examples of R₁ to R₁₃ include an optionally substituted alkoxy group having 1 to 20 carbon atoms. Examples of the substituent include a halogen atom, a hydroxy group, a carboxy group, and an alkyl group.

Examples of the optionally substituted aryl group in specific examples of R₁ to R₁₃ include an optionally substituted aryl group having 6 to 20 carbon atoms. Examples of the substituent include a halogen atom, a hydroxy group, a carboxy group, an alkyl group, and an alkoxy group.

Specific examples of the optionally substituted alkyl group in R₂₁, R₂₂, R₃₁, and R₃₂ include specific examples of the optionally substituted alkyl group in specific examples of R₁ to R₁₃.

Specific examples of the optionally substituted aryl group in R₂₁, R₂₂, R₃₁, and R₃₂ include specific examples of the optionally substituted aryl group in specific examples of R₁ to R₁₃.

Examples of the alkyl group as the substituent include an alkyl group having 1 to 6 carbon atoms.

Examples of the alkoxy group as the substituent include an alkoxy group having 1 to 6 carbon atoms.

The term "1 to 20 carbon atoms" in the "optionally substituted alkyl group having 1 to 20 carbon atoms" refers to the number of carbon atoms excluding the number of carbon atoms in the substituent. The same applies to the "optionally substituted aryl group having 6 to 20 carbon atoms" and the "optionally substituted alkoxy group having 1 to 20 carbon atoms".

The light-absorbing structured second unit can be prepared, for example, by using a monomer having a light-absorbing structure and polymerizing the monomer. Examples of the monomer having a light-absorbing structure include acenaphthylene, 2-vinylnaphthalene, vinyl cinnamate, 4-benzoylphenyl methacrylate, and 2-[2-hydroxy-5-[2-(methacryloyloxy)ethyl]phenyl]-2-H-benzotriazole.

The light-absorbing structured second unit is preferably a unit represented by any one of the following Formulae (B-1) to (B-5):

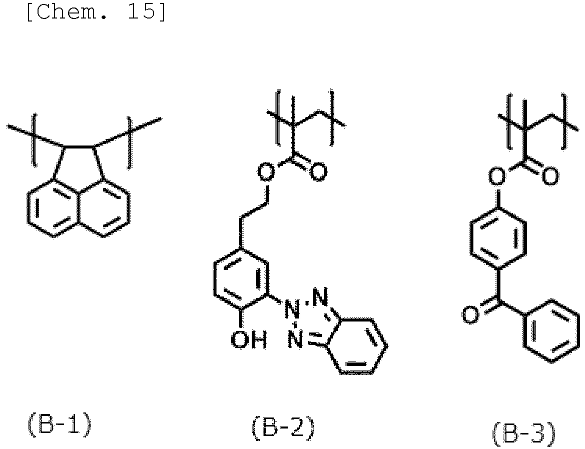

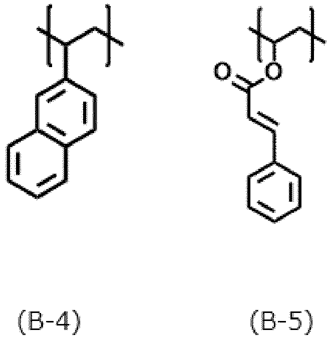

### <<Third Unit>>

The (meth)acrylic polymer according to the present invention preferably further includes a third unit represented by the following Formula (C-1) or (C-2), in addition to the first unit and the second unit: 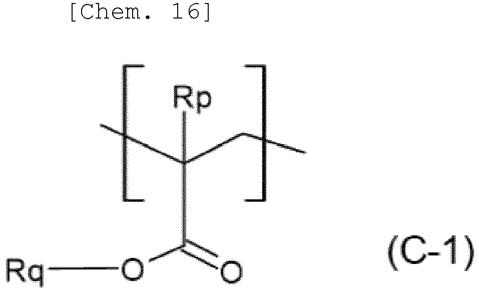 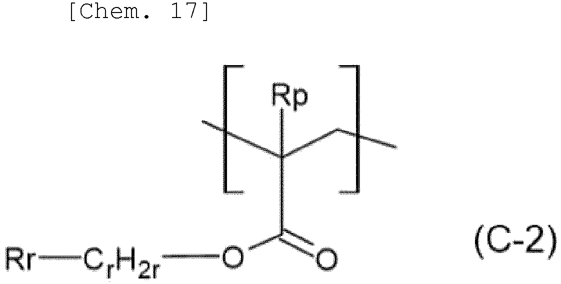 where in Formulae (C-1) and (C-2), Rp represents a hydrogen atom or a methyl group, Rq represents a chain saturated hydrocarbon group having 3 or more carbon atoms, Rr represents an aromatic hydrocarbon group or an aliphatic hydrocarbon group having 6 or more carbon atoms, and r represents an integer of 0 or more.

In Rr, the aromatic hydrocarbon group and the aliphatic hydrocarbon group may each be a monocyclic ring or a condensed ring, or a linked ring in which any ring selected from these rings is linked. Alternatively, the aromatic hydrocarbon group and the aliphatic hydrocarbon group may be linked to each other.

The third unit is effective as a unit for enhancing compatibility between the first unit and the second unit.

The third unit can be prepared, for example, by using a monomer represented by the following Formula (C-1-1) or (C-2-1) and polymerizing the monomer. Examples of the monomer represented by the following Formula (C-1-1) or (C-2-1) include stearyl methacrylate, hexyl acrylate, docosyl acrylate, benzyl methacrylate, and dicyclopentanyl methacrylate:

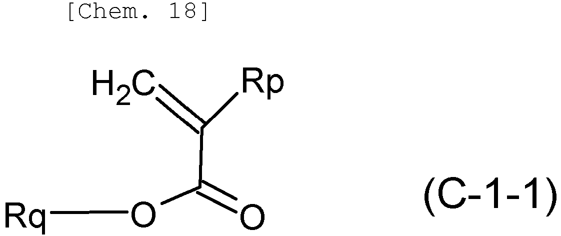

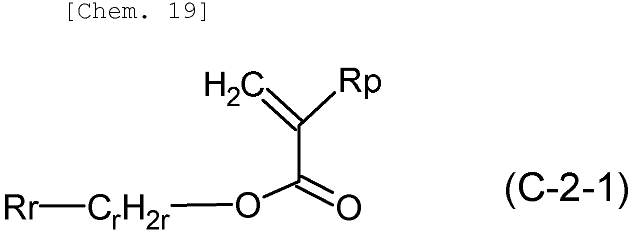

The third unit is preferably a unit represented by any one of the following Formulae (C-3) to (C-7):

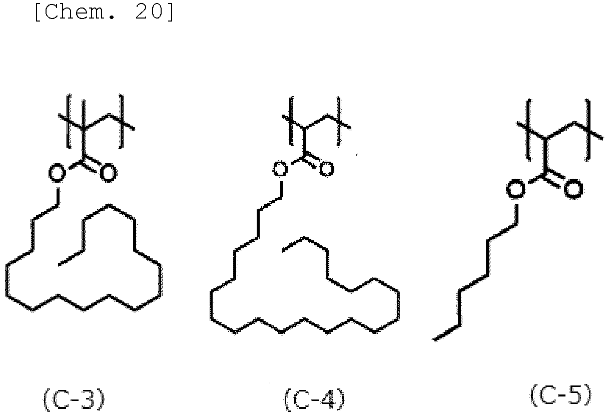

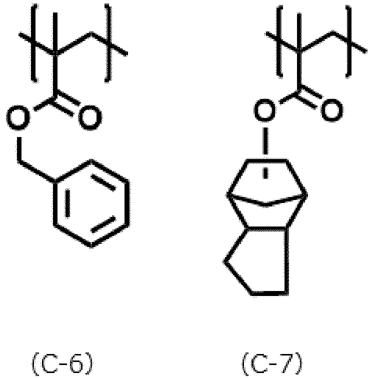

In mixing of the release agent component (R) with the adhesive component (S), for example, even when a polymer having only the light-absorbing structured second unit is used to mix the components, the compatibility with the adhesive component (S) is poor, and the mixture becomes cloudy. Thus, in the present invention, the first unit that has good solubility in the adhesive component is used, and a polymer having the first unit and the second unit is mixed with the adhesive component (S) such that the solubility of the polymer in the adhesive component (S) is increased and the turbidity of the mixture is not caused.

However, the solubility between the first unit and the second unit is not sufficient. Accordingly, in the present invention, a more preferred aspect is that the third unit for increasing the compatibility between the first unit and the second unit is included in the polymer in order to prevent the turbidity of the polymer itself having the first unit and the second unit.

Hence, in a more preferred aspect of the present invention, a polymer having the first unit, the second unit, and the third unit is mixed with the adhesive component (S). Consequently, even when the polymer is mixed with the adhesive component (S), the turbidity of the mixture is not caused, and the turbidity of the polymer itself to be mixed with the adhesive component (S) can also be prevented.

### <<Ratio of Units in (Meth)acrylic polymer>>

In the (meth)acrylic polymer having the first unit and the second unit, the ratio of the first unit and the second unit is not particularly limited as long as the effect of the present invention is exerted, and can be appropriately set. For example, the mass ratio of the first unit : the second unit is preferably 5 : 5 to 8 : 2.

Further, in the (meth)acrylic polymer having the first unit, the second unit, and the third unit, the ratio of the first unit, the second unit, and the third unit is not particularly limited as long as the effect of the present invention is exerted, and can be appropriately set. For example, the mass ratio of the first unit : the second unit : the third unit is preferably 1 to 8 : 1 to 5 : 1 to 2, more preferably 5 to 8 : 2 to 5 : 1 to 2, and particularly preferably 7 : 2 : 1.

### <<Preparation of (Meth)acrylic polymer>>

A monomer for preparing the first unit and the second unit (including the third unit when the third unit is included) is mixed. Since the mixture contains a compound having a radically polymerizable (meth)acrylate group, the mixture is mixed with a radical initiator that generates radicals upon heat and heated for radical polymerization, thereby preparing a (meth)acrylic polymer including the first unit and the second unit (including the third unit when the third unit is included). The mixture may be further mixed with a solvent for the purpose of adjusting the viscosity or the like.

Examples of the thermal radical initiator that generates radicals upon heat include a compound having a ketone peroxide structure, a peroxyketal structure, a hydroperoxide structure, a dialkyl peroxide structure, a diacyl peroxide structure, a peroxyester structure, a peroxydicarbonate structure, or an azo-based structure. The use of the thermal radical initiator that generates gas during generation of radicals may cause generation of voids. Therefore, the thermal radical initiator is preferably a compound having a ketone peroxide structure, a peroxyketal structure, a hydroperoxide structure, a dialkyl peroxide structure, a diacyl peroxide structure, a peroxyester structure, or a peroxydicarbonate structure.

Specific examples of the compound include diisobutyryl peroxide, cumylperoxyneodecanoate, di-n-propylperoxydicarbonate, diisopropylperoxydicarbonate, di-sec-butylperoxydicarbonate, 1,1,3,3-tetramethylbutylperoxyneodecanoate, di(4-tert-butylcyclohexyl)peroxydicarbonate, di(2-ethylhexyl)peroxydicarbonate, tert-hexylperoxyneodecanoate, tert-butylperoxyneodecanoate, tert-butylperoxyneoheptanoate, tert-hexylperoxypivalate, tert-butylperoxypivalate, di(3,5,5-trimethylhexanoyl)peroxide, dilauryl peroxide, 1,1,3,3-tetramethylbutylperoxy-2-ethylhexanoate, disuccinic acid peroxide, 2,5-dimethyl-2,5-di-(2-ethylhexanoylperoxy)hexane, tert-hexylperoxy-2-ethylhexanoate, di(4-methylbenzoyl)peroxide, tert-butylperoxy-2-ethylhexanoate, dibenzoyl peroxide, 1,1-di(t-butylperoxy)-2-methylcyclohexane, 1,1-di(tert-hexylperoxy)-3,3,5-trimethylcyclohexane, 1,1-di(tert-hexylperoxy)cyclohexane, 1,1-di(tert-butylperoxy)cyclohexane, 2,2-di(4,4-di-(tert-butylperoxy)cyclohexyl)propane, tert-hexylperoxyisopropylmonocarbonate, tert-butylperoxymaleic acid, tert-butylperoxy-3,5,5-trimethylhexanoate, tert-butylperoxylaurate, tert-butylperoxyisopropylmonocarbonate, tert-butylperoxy-2-ethylhexylmonocarbonate, tert-hexylperoxybenzoate, 2,5-di-methyl-2,5-di(benzoylperoxy)hexane, tert-butylperoxyacetate, 2,2-di-(tert-butylperoxy)butane, tert-butylperoxybenzoate, n-butyl-4,4-di-(tert-butylperoxy)valerate, di(2-tert-butylperoxyisopropyl)benzene, dicumyl peroxide, di-tert-hexyl peroxide, 2,5-dimethyl-2,5-di-tert-butylperoxy)hexane, tert-butylcumyl peroxide, di-tert-butyl peroxide, p-menthane hydroperoxide, 2,5-dimethyl-2,5-di(tert-butylperoxy)-3-hexyne, diisopropylbenzene hydroperoxide, 1,1,3,3-tetramethylbutyl hydroperoxide, cumene hydroperoxide, and tert-butyl hydroperoxide.

More specific examples of the compound include PEROYL IB, PERCUMYL ND, PEROYL NPP, PEROYL IPP, PEROYL SBP, PEROCTA ND, PEROYL TCP, PEROYL OPP, PERHEXYL ND, PERBUTYL ND, PERBUTYL NHP, PERHEXYL PV, PERBUTYL PV, PEROYL 355, PEROYL L, PEROCTA O, PEROYL SA, PERHEXA 25O, PERHEXYL O, NYPER PMB, PERBUTYL O, NYPER BMT, NYPER BW, PERHEXA MC, PERHEXA TMH, PERHEXA HC, PERHEXA C, PERTETRA A, PERHEXYL I, PERBUTYL MA, PERBUTYL 355, PERBUTYL L, PERBUTYL I, PERBUTYL E, PERHEXYL Z, PERHEXA 25Z, PERBUTYL A, PERHEXA 22, PERBUTYL Z, PERHEXA V, PERBUTYL P, PERCUMYL D, PERHEXYL D, PERHEXA 25B, PERBUTYL C, PERBUTYL D, PERMENTA H, PERHEXYNE 25B, PERCUMYL P, PEROCTA H, PERCUMYL H, PERBUTYL H, and NOFMER BC (all products manufactured by NOF CORPORATION).

Among these products, di(4-tert-butylcyclohexyl)peroxydicarbonate (PEROYL TCP/NOF CORPORATION), tert-butylperoxypivalate (PERBUTYL PV/NOF CORPORATION), 1,1,3,3-tetramethylbutylperoxy-2-ethylhexanoate (PEROCTA O/NOF CORPORATION), 1,1-di(tert-hexylperoxy)cyclohexane (PERHEXA HC/NOF CORPORATION), 2,5-dimethyl-2,5-di(benzoylperoxy)hexane (PERHEXA 25Z/NOF CORPORATION), tert-butylperoxybenzoate (PERBUTYL Z/manufactured by NOF CORPORATION) and di(2-tert-butylperoxyisopropyl)benzene (PERBUTYL P/manufactured by NOF CORPORATION) are preferably used, from the viewpoint of reactivity and reaction starting temperature.

Specific examples of the solvent include, but are not limited to, aliphatic hydrocarbons, aromatic hydrocarbons, and ketones.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone.

Further, examples of the solvent include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether (PGME), propylene glycol monomethyl ether acetate (PGMEA), propylene glycol monoethyl ether, propylene glycol monoethyl ether acetate, propylene glycol propyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, and butyl lactate.

These solvents may be used singly or in combination of two or more kinds thereof.

The adhesive composition of the present invention contains the adhesive component (S) and the release agent component (R).

The ratio of the adhesive component (S) and the release agent component (R) is not particularly limited as long as the effect of the present invention is exerted, and can be appropriately selected according to the purpose. Preferably, the ratio is, for example, 50 : 50 to 95 : 5, in terms of mass ratio.

### <Additional Component>

The adhesive composition of the present invention may contain a solvent for the purpose of adjusting the viscosity or the like, or for favorably dissolving components forming a film.

Specific examples of the solvent include the same solvents as those described in the section of <<Preparation of (Meth)acrylic polymer>>.

### (Laminate)

The laminate of the present invention includes a semiconductor substrate, a support substrate, and a light-releasable adhesive layer.

The support substrate has light transmittivity.

The light-releasable adhesive layer is provided between the semiconductor substrate and the support substrate.

The laminate is used for releasing the semiconductor substrate and the support substrate each other after the adhesive layer absorbs light emitted from a side of the support substrate.

The light-releasable adhesive layer is a layer formed of the adhesive composition for release by light irradiation of the present invention as described above.

The laminate of the present invention is used for temporary adhesion in order to process a semiconductor substrate, and can be suitably used for processing, such as thinning, of the semiconductor substrate.

The semiconductor substrate is supported on the support substrate via the adhesive layer while the semiconductor substrate is subjected to processing such as thinning. On the other hand, after the processing of the semiconductor substrate, the adhesive layer is irradiated with light, and then, the support substrate and the semiconductor substrate are separated from each other.

The adhesive layer according to the present invention causes the semiconductor substrate and support substrate irradiated with light to be easily separated from each other. Further, after the semiconductor substrate and the support substrate are separated from each other, the residue of the adhesive layer remaining on the semiconductor substrate or the support substrate can be removed by, for example, a cleaning agent composition for cleaning a semiconductor substrate.

For example, the wavelength of light used for release is preferably 250 to 600 nm, more preferably 250 to 370 nm. More preferably, the wavelength is 308 nm, 343 nm, 355 nm, 365 nm, or 532 nm. The irradiation amount of light required for release is an irradiation amount that can cause preferred alternation, for example, decomposition of a specific light-absorbing compound.

The light used for release may be laser light or non-laser light emitted from a light source such as an ultraviolet lamp.

### <Semiconductor Substrate>

The main material forming the entire semiconductor substrate is not particularly limited as long as it is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface, and for example, the outer periphery of the semiconductor substrate may have a straight portion called an orientation flat or may have a cut called a notch.

The thickness of the disk-shaped semiconductor substrate may be appropriately determined according to the purpose of use of the semiconductor substrate and the like, and is not particularly limited, and is, for example, 500 to 1,000 µm.

The diameter of the disk-shaped semiconductor substrate may be appropriately determined according to the purpose of use of the semiconductor substrate and the like, and is not particularly limited, and is, for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is ordinarily formed on a surface on which a circuit is formed. The circuit may be a single layer or a multilayer. The shape of the circuit is not particularly limited.

In the semiconductor substrate, the surface opposite to the surface having a bump (rear surface) is a surface to be processed.

The material, size, shape, structure, and density of the bump of the semiconductor substrate are not particularly limited.

Examples of the bump include a ball bump, a printed bump, a stud bump, and a plated bump.

Ordinarily, the height, radius, and pitch of the bump are appropriately determined from the conditions of a bump height of about 1 to 200 µm, a bump radius of 1 to 200 µm, and a bump pitch of 1 to 500 µm.

Examples of the material of the bump include low-melting-point solder, high-melting-point solder, tin, indium, gold, silver, and copper. The bump may be composed only of a single component or may be composed of a plurality of components. More specific examples thereof include alloy plating mainly containing Sn, such as SnAg bumps, SnBi bumps, Sn bumps, and AuSn bumps.

In addition, the bump may have a layered structure including a metal layer composed of at least one of these components.

An example of the semiconductor substrate is a silicon wafer having a diameter of about 300 mm and a thickness of about 770 µm.

### <Support Substrate>

The support substrate is not particularly limited as long as it is a member that is light-transmissive to light emitted to the adhesive layer and can support the semiconductor substrate when the semiconductor substrate is processed, and examples thereof include a glass support substrate.

The shape of the support substrate is not particularly limited, and examples thereof include a disk shape.

The thickness of the disk-shaped support substrate may be appropriately determined according to the size of the semiconductor substrate and the like, and is not particularly limited, and is, for example, 500 to 1,000 µm.

The diameter of the disk-shaped support substrate may be appropriately determined according to the size of the semiconductor substrate and the like, and is not particularly limited, and is, for example, 100 to 1,000 mm.

An example of the support substrate is a glass wafer having a diameter of about 300 mm and a thickness of about 700 µm.

### <Adhesive Layer>

The adhesive layer is provided between the support substrate and the semiconductor substrate.

The adhesive layer is in contact with, for example, the semiconductor substrate, and is in contact with the support substrate.

The adhesive layer is formed using the adhesive composition for release by light irradiation of the present invention described above.

The adhesive composition of the present invention can be suitably used for forming an adhesive layer of a laminate including a semiconductor substrate, a support substrate, and an adhesive layer provided between the semiconductor substrate and the support substrate. The laminate is used for releasing the semiconductor substrate and the support substrate each other after the adhesive layer absorbs light emitted from a side of the support substrate.

One of the characteristics of the adhesive layer prepared from the adhesive composition of the present invention is that the semiconductor substrate and the support substrate can be easily separated from each other after light irradiation.

The thickness of the adhesive layer is not particularly limited, and is ordinarily 5 to 500 µm, and is preferably 10 µm or more, more preferably 20 µm or more, and still more preferably 30 µm or more, from the viewpoint of maintaining the film strength, and is preferably 200 µm or less, more preferably 150 µm or less, still more preferably 120 µm or less, and yet still more preferably 70 µm or less, from the viewpoint of avoiding non-uniformity caused by a thick film.

The method for forming the adhesive layer from the adhesive composition will be described in detail in <Method for Producing Laminate> described below.

The laminate of the present invention is suitably produced, for example, by the following method for producing a laminate of the present invention.

Hereinafter, an example of the laminate will be described with reference to the drawings.

Fig. 1 is a schematic cross-sectional view of an example of a laminate.

The laminate of Fig. 1 includes a semiconductor substrate 1, an adhesive layer 2, and a support substrate 3 in this order.

The adhesive layer 2 is provided between the semiconductor substrate 1 and the support substrate 3. The adhesive layer 2 is in contact with the semiconductor substrate 1 and the support substrate 3.

### <Method for Producing Laminate>

The laminate of the present invention can be produced, for example, by a method including: a first step of applying an adhesive composition to the surface of either of the semiconductor substrate or the support substrate and heating the adhesive composition as necessary to form an adhesive coating layer; and a second step of bonding the semiconductor substrate, the adhesive coating layer, and the support substrate to one another while bonding the semiconductor substrate and the support substrate to each other with the adhesive coating layer interposed therebetween and performing at least one of a heat treatment or a decompression treatment.

The second step will be described in more detail. Examples of the second step include steps of Embodiment (i) and Embodiment (ii) below.
(i) When the adhesive composition is applied to the surface of the semiconductor substrate, the adhesive coating layer of the semiconductor substrate and the support substrate are brought into close contact with each other by applying a load in the thickness direction of the semiconductor substrate and the support substrate while performing at least one of a heat treatment or a decompression treatment, and then a post-heat treatment is performed to form a laminate.
(ii) When the adhesive composition is applied to the surface of the support substrate, the adhesive coating layer of the support substrate and the semiconductor substrate are brought into close contact with each other by applying a load in the thickness direction of the semiconductor substrate and the support substrate while performing at least one of a heat treatment or a decompression treatment, and then a post-heat treatment is performed to form a laminate.

The application method is not particularly limited, and is ordinarily a spin coating method. Note that it is possible to employ a method of separately forming a coating film by a spin coating method or the like and attaching the sheet-like coating film as an adhesive coating layer.

The heating temperature of the applied adhesive composition varies depending on the type and amount of the adhesive component contained in the adhesive composition, whether or not a solvent is contained, the boiling point of the solvent used, the desired thickness of the adhesive layer, and the like, and thus cannot be generally specified. The heating temperature is ordinarily 80 to 200°C, and the heating time is ordinarily 30 seconds to 10 minutes.

When the adhesive composition contains a solvent, the applied adhesive composition is ordinarily heated.

The heating can be performed using a hot plate, an oven, or the like.

The film thickness of the adhesive coating layer prepared by applying the adhesive composition and heating the adhesive composition as necessary is ordinarily about 5 to 500 µm, and appropriately determined so as to finally fall within the range of the thickness of the adhesive layer described above.

In the present invention, the laminate of the present invention can be prepared by a method including: combining the semiconductor substrate and the support substrate so as to be in contact with the adhesive layer; bringing the two layers into close contact with each other by applying a load in the thickness direction of the semiconductor substrate and the support substrate while performing a heating treatment or a decompression treatment or both; and then performing a post-heat treatment. Which treatment condition of heat treatment, decompression treatment, and combination use of both is adopted is appropriately determined in consideration of various circumstances such as the type of the adhesive composition, the specific composition of the release agent composition, the compatibility of the films obtained from both the compositions, the film thickness, and the required adhesive strength.

The heat treatment is appropriately determined from the range of ordinarily 20 to 150°C from the viewpoint that when a solvent is contained in the composition, the solvent is removed, the viewpoint that the adhesive coating layer is softened to realize suitable bonding with the release agent coating layer, and the like. In particular, from the viewpoint of suppressing or avoiding excessive curing and unnecessary alteration of the adhesive component (S), the heating temperature is preferably 130°C or lower, more preferably 90°C or lower, and the heating time is appropriately determined according to the heating temperature and the type of the adhesive. However, from the viewpoint of reliably exhibiting suitable adhesion, the heating time is ordinarily 30 seconds or longer, and preferably 1 minute or longer. From the viewpoint of suppressing alteration of the adhesive layer and other members, the heating time is ordinarily 10 minutes or shorter, and preferably 5 minutes or shorter.

In the decompression treatment, the adhesive coating layer may be exposed under an atmospheric pressure of 10 to 10,000 Pa. The time for the decompression treatment is ordinarily 1 to 30 minutes.

The load in the thickness direction of the semiconductor substrate and the support substrate is not particularly limited as long as the load does not adversely affect the semiconductor substrate, the support substrate, and the two layers therebetween, and can make the substrates and the layers stick together. Ordinarily, the load is within a range of 10 to 1000 N.

The post-heating temperature is preferably 120°C or higher from the viewpoint of realizing a sufficient curing rate and the like, and is preferably 260°C or lower from the viewpoint of preventing alternation of the substrate and each layer and the like.

The post-heating time is ordinarily 1 minute or longer, and preferably 5 minutes or longer from the viewpoint of realizing preferred bonding of the substrate and the layer forming the laminate, and is ordinarily 180 minutes or shorter, and preferably 120 minutes or shorter from the viewpoint of suppressing or avoiding an adverse effect on each layer due to excessive heating.

The heating can be performed using a hot plate, an oven, or the like. In a case where post-heating is performed using a hot plate, heating may be performed with either the semiconductor substrate or the support substrate of the laminate facing downward. Preferably, post-heating is performed with the semiconductor substrate facing downward from the viewpoint of realizing preferred release with excellent reproducibility.

Note that one object of the post-heat treatment is to realize an adhesive layer as a more preferred self-standing film, and to suitably realize, particularly, curing by a hydrosilylation reaction.

### (Method for Producing Processed Semiconductor Substrate)

The method for producing a processed semiconductor substrate of the present invention includes a third step and a fourth step.

The third step is a step of processing the semiconductor substrate of the laminate of the present invention.

The fourth step is a step of separating the processed semiconductor substrate in the third step and the support substrate from each other.

The processing performed on the semiconductor substrate in the third step is, for example, processing on an opposite side of a circuit surface of a wafer, and includes thinning of the wafer by polishing the rear surface of the wafer. Thereafter, a through-silicon via (TSV) or the like is formed, and then the thinned wafer is released from the support substrate to form a laminate of the wafers, and the wafers are three-dimensionally mounted. Before and after that, an electrode on the rear surface of the wafer is also formed. In the process of thinning the wafer and the TSV process, heat at about 250 to 350°C is applied in a state of being bonded to the support substrate. Ordinarily, the laminate of the present invention includes an adhesive layer and has heat resistance to the load.

Note that the processing is not limited to the processing described above, and includes, for example, implementation of a process of mounting a semiconductor component in a case where a base material for mounting a semiconductor component is temporarily bonded to the support substrate to support the base material.

In the fourth step, examples of the method for separating (releasing) the semiconductor substrate and the support substrate from each other include, but are not limited to, mechanical release with equipment having a sharp portion after irradiation of the adhesive layer with light, and release by pulling up between the support and the wafer.

The adhesive layer is irradiated with light from the side of the support substrate, the adhesive layer is altered (for example, separation or decomposition of the adhesive layer) as described above, and thereafter, for example, one of the substrates is pulled up, and the semiconductor substrate and the support substrate can be easily separated from each other.

The adhesive layer is not necessarily irradiated with light in the entire region of the adhesive layer. Even when the region irradiated with light and the region not irradiated with light are mixed, the semiconductor substrate and the support substrate can be separated from each other by a slight external force such as pulling up of the support substrate, for example, as long as the releasability is sufficiently improved in the entire adhesive layer. The ratio and positional relationship between the region irradiated with light and the region not irradiated with light vary depending on the type and specific composition of the adhesive to be used, the thickness of the adhesive layer, the thickness of the adhesive layer, the intensity of light to be irradiated, and the like, but those skilled in the art can appropriately set conditions without requiring an excessive test. For such circumstances, according to the method for producing a processed semiconductor substrate of the present invention, for example, in a case where the support substrate of the laminate to be used has light transmittivity, it is possible to shorten the light irradiation time when release is performed through light irradiation from the side of the support substrate. As a result, not only improvement in throughput can be expected, but also physical stress and the like for release can be avoided, and the semiconductor substrate and the support substrate can be easily and efficiently separated from each other only through light irradiation.

Ordinarily, an irradiation amount of light for release is 50 to 3,000 mJ/cm². The irradiation time is appropriately determined according to the wavelength and the irradiation dose.

As described above, for example, the wavelength of light used for release is preferably 250 to 600 nm, more preferably 250 to 370 nm. More preferably, the wavelength is 308 nm, 343 nm, 355 nm, 365 nm, or 532 nm. The irradiation amount of light required for release is an irradiation amount that can cause preferred alternation, for example, decomposition of a specific light-absorbing compound.

The light used for release may be laser light or non-laser light emitted from a light source such as an ultraviolet lamp.

The substrate can be cleaned by spraying the cleaning agent composition onto the surface of at least one of the separated semiconductor substrate or the separated support substrate, or immersing the separated semiconductor substrate or the separated support substrate in the cleaning agent composition.

Alternatively, the surface of the processed semiconductor substrate or the like may be cleaned using a removal tape or the like.

The constituent elements and method elements related to the steps of the method for producing a processed semiconductor substrate of the present invention may be variously changed without departing from the gist of the present invention.

The method for producing a processed semiconductor substrate of the present invention may include steps other than the steps described above.

In the releasing step according to the present invention, in a case where the semiconductor substrate or the support substrate of the laminate of the present invention has light transmittivity, the semiconductor substrate and the support substrate of the laminate are separated from each other by irradiating the adhesive layer with light from the side of the semiconductor substrate or the support substrate.

In the laminate of the present invention, the semiconductor substrate and the support substrate are temporarily bonded by the adhesive layer so as to be suitably releasable. Therefore, for example, in a case where the support substrate has light transmittivity, the adhesive layer is irradiated with light from the side of the support substrate of the laminate, and thus the semiconductor substrate and the support substrate can be easily separated from each other. Ordinarily, release is performed after the semiconductor substrate of the laminate is processed.

### Examples

Hereinafter, the present invention will be described more specifically with reference to Examples, but the present invention is not limited to only the following Examples. Note that the apparatuses used are as follows.

### [Apparatuses]

(1) Stirrer: planetary centrifugal mixer ARE-500, manufactured by THINKY
(2) Viscometer: rotational viscometer TVE-22H, manufactured by Toki Sangyo Co., Ltd.
(3) Vacuum bonding apparatus: manual bonder, manufactured by SUSS MicroTec SE.
(4) Laser irradiation device: NC-LD300 EXC, manufactured by Optec Inc.

### [1] Preparation of Adhesive Composition

### [Preparation Example 1] Preparation of Adhesive Component

A 600 mL stirring vessel dedicated to a stirrer was charged with 80 g of an MQ resin (manufactured by Wacker Chemie AG) containing a polysiloxane and a vinyl group as the polyorganosiloxane (a1), 2.52 g of a SiH group-containing linear polydimethylsiloxane (manufactured by Wacker Chemie AG) having a viscosity of 100 mPa·s as the polyorganosiloxane (a2), 5.89 g of a SiH group-containing linear polydimethylsiloxane (manufactured by Wacker Chemie AG) having a viscosity of 70 mPa·s as the polyorganosiloxane (a2), and 0.22 g of 1-ethynylcyclohexanol (manufactured by Wacker Chemie AG) as the polymerization inhibitor (A3), and stirred with the stirrer for 5 minutes.

To the resultant mixture, 3.96 g of a mixture prepared by stirring 0.147 g of a platinum catalyst (manufactured by Wacker Chemie AG) as the platinum group metal-based catalyst (A2) and 5.81 g of a vinyl group-containing linear polydimethylsiloxane (manufactured by Wacker Chemie AG) having a viscosity of 1000 mPa·s as the polyorganosiloxane (a1) with the stirrer for 5 minutes was added, and the mixture was stirred with the stirrer for 5 minutes.

Finally, the resultant mixture was filtered through a nylon filter (300 mesh) to form an adhesive component 1. The viscosity of the adhesive measured with a viscometer was 10,000 mPa·s.

### [Preparation Example 2] Preparation of Release Agent Component- Polymerization of (Meth)acrylic polymer

A 100 mL glass bottle was charged with 25.7 g of KF-2012 (manufactured by Shin-Etsu Chemical Co., Ltd.), 12.4 g of acenaphthylene (manufactured by Tokyo Chemical Industry Co., Ltd.), 4.2 g of hexyl acrylate (manufactured by Tokyo Chemical Industry Co., Ltd.), 4.2 g of PERBUTYL P (manufactured by NOF CORPORATION), and 43.2 g of mesitylene (manufactured by Tokyo Chemical Industry Co., Ltd.), and the mixture was stirred to prepare a solution -1. Separately, a 300 mL recovery flask was charged with 57.5 g of mesitylene (manufactured by Tokyo Chemical Industry Co., Ltd.) and heated in an oil bath at 100°C while stirring the component with a stirrer, and the solution -1 was added dropwise to the flask. After the dropwise addition, the solution was directly heated and stirred for 24 hours, and the recovered polymer solution was used as a release agent component 1.

### [Preparation Example 3] Preparation of Release Agent Component- Polymerization of (Meth)acrylic polymer

A 100 mL glass bottle was charged with 30.0 g of KF-2012 (manufactured by Shin-Etsu Chemical Co., Ltd.), 8.5 g of 2-vinylnaphthalene (manufactured by Tokyo Chemical Industry Co., Ltd.), 4.2 g of hexyl acrylate (manufactured by Tokyo Chemical Industry Co., Ltd.), 4.2 g of PERBUTYL P (manufactured by NOF CORPORATION), and 43.2 g of mesitylene (manufactured by Tokyo Chemical Industry Co., Ltd.), and the mixture was stirred to prepare a solution -2. Separately, a 300 mL recovery flask was charged with 57.5 g of mesitylene (manufactured by Tokyo Chemical Industry Co., Ltd.) and heated in an oil bath at 100°C while stirring the component with a stirrer, and the solution -2 was added dropwise to the flask. After the dropwise addition, the solution was directly heated and stirred for 24 hours, and the recovered polymer solution was used as a release agent component 2.

### [Preparation Example 4] Preparation of Release Agent Component- Polymerization of (Meth)acrylic polymer

A 100 mL glass bottle was charged with 25.7 g of KF-2012 (manufactured by Shin-Etsu Chemical Co., Ltd.), 12.4 g of 2-vinylnaphthalene (manufactured by Tokyo Chemical Industry Co., Ltd.), 4.2 g of hexyl acrylate (manufactured by Tokyo Chemical Industry Co., Ltd.), 4.2 g of PERBUTYL P (manufactured by NOF CORPORATION), and 43.2 g of mesitylene (manufactured by Tokyo Chemical Industry Co., Ltd.), and the mixture was stirred to prepare a solution -3. Separately, a 300 mL recovery flask was charged with 57.5 g of mesitylene (manufactured by Tokyo Chemical Industry Co., Ltd.) and heated in an oil bath at 100°C while stirring the component with a stirrer, and the solution -3 was added dropwise to the flask. After the dropwise addition, the solution was directly heated and stirred for 24 hours, and the recovered polymer solution was used as a release agent component 3.

### [Preparation Example 5] Preparation of Release Agent Component- Polymerization of (Meth)acrylic polymer

A 100 mL glass bottle was charged with 21.2 g of KF-2012 (manufactured by Shin-Etsu Chemical Co., Ltd.), 10.6 g of acenaphthylene (manufactured by Tokyo Chemical Industry Co., Ltd.), 10.6 g of stearyl methacrylate (manufactured by Tokyo Chemical Industry Co., Ltd.), 4.2 g of PERBUTYL P (manufactured by NOF CORPORATION), and 43.2 g of mesitylene (manufactured by Tokyo Chemical Industry Co., Ltd.), and the mixture was stirred to prepare a solution -4. Separately, a 300 mL recovery flask was charged with 57.5 g of mesitylene (manufactured by Tokyo Chemical Industry Co., Ltd.) and heated in an oil bath at 100°C while stirring the component with a stirrer, and the solution -4 was added dropwise to the flask. After the dropwise addition, the solution was directly heated and stirred for 24 hours, and the recovered polymer solution was used as a release agent component 4.

### [Preparation Example 6] Preparation of Release Agent Component- Polymerization of (Meth)acrylic polymer

A 100 mL glass bottle was charged with 21.2 g of KF-2012 (manufactured by Shin-Etsu Chemical Co., Ltd.), 17.1 g of vinyl cinnamate (manufactured by Tokyo Chemical Industry Co., Ltd.), 4.2 g of hexyl acrylate (manufactured by Tokyo Chemical Industry Co., Ltd.), 4.2 g of PERBUTYL P (manufactured by NOF CORPORATION), and 43.2 g of mesitylene (manufactured by Tokyo Chemical Industry Co., Ltd.), and the mixture was stirred to prepare a solution -5. Separately, a 300 mL recovery flask was charged with 57.5 g of mesitylene (manufactured by Tokyo Chemical Industry Co., Ltd.) and heated in an oil bath at 100°C while stirring the component with a stirrer, and the solution -5 was added dropwise to the flask. After the dropwise addition, the solution was directly heated and stirred for 24 hours, and the recovered polymer solution was used as a release agent component 5.

### [Preparation Example 7] Preparation of Release Agent Component- Polymerization of (Meth)acrylic polymer

A 100 mL glass bottle was charged with 21.2 g of X-22-167 C (manufactured by Shin-Etsu Chemical Co., Ltd.), 21.2 g of 2-vinylnaphthalene (manufactured by Tokyo Chemical Industry Co., Ltd.), 4.2 g of PERBUTYL P (manufactured by NOF CORPORATION), and 43.2 g of mesitylene (manufactured by Tokyo Chemical Industry Co., Ltd.), and the mixture was stirred to prepare a solution -6. Separately, a 300 mL recovery flask was charged with 57.5 g of mesitylene (manufactured by Tokyo Chemical Industry Co., Ltd.) and heated in an oil bath at 100°C while stirring the component with a stirrer, and the solution -6 was added dropwise to the flask. After the dropwise addition, the solution was directly heated and stirred for 24 hours, and the recovered polymer solution was used as a release agent component 6.

### [Preparation Example 8] Preparation of Release Agent Component- Polymerization of (Meth)acrylic polymer

A 100 mL glass bottle was charged with 21.2 g of X-22-167 C (manufactured by Shin-Etsu Chemical Co., Ltd.), 21.2 g of acenaphthylene (manufactured by Tokyo Chemical Industry Co., Ltd.), 4.2 g of PERBUTYL P (manufactured by NOF CORPORATION), and 43.2 g of mesitylene (manufactured by Tokyo Chemical Industry Co., Ltd.), and the mixture was stirred to prepare a solution -7. Separately, a 300 mL recovery flask was charged with 57.5 g of mesitylene (manufactured by Tokyo Chemical Industry Co., Ltd.) and heated in an oil bath at 100°C while stirring the component with a stirrer, and the solution -7 was added dropwise to the flask. After the dropwise addition, the solution was directly heated and stirred for 24 hours, and the recovered polymer solution was used as a release agent component 7.

### [Preparation Example 9] Preparation of Release Agent Component- Polymerization of (Meth)acrylic polymer

A 100 mL glass bottle was charged with 21.2 g of KF-2012 (manufactured by Shin-Etsu Chemical Co., Ltd.), 17.1 g of 4-benzoylphenyl methacrylate (manufactured by Tokyo Chemical Industry Co., Ltd.), 4.2 g of hexyl acrylate (manufactured by Tokyo Chemical Industry Co., Ltd.), 4.2 g of PERBUTYL P (manufactured by NOF CORPORATION), and 43.2 g of mesitylene (manufactured by Tokyo Chemical Industry Co., Ltd.), and the mixture was stirred to prepare a solution - 8. Separately, a 300 mL recovery flask was charged with 57.5 g of mesitylene (manufactured by Tokyo Chemical Industry Co., Ltd.) and heated in an oil bath at 100°C while stirring the component with a stirrer, and the solution -8 was added dropwise to the flask. After the dropwise addition, the solution was directly heated and stirred for 24 hours, and the recovered polymer solution was used as a release agent component 8.

### [Preparation Example 10] Preparation of Release Agent Component- Polymerization of (Meth)acrylic polymer

A 100 mL glass bottle was charged with 21.2 g of KF-2012 (manufactured by Shin-Etsu Chemical Co., Ltd.), 17.1 g of 2-[2-hydroxy-5-[2-(methacryloyloxy)ethyl]phenyl]-2-H-benzotriazole (manufactured by Tokyo Chemical Industry Co., Ltd.), 4.2 g of hexyl acrylate (manufactured by Tokyo Chemical Industry Co., Ltd.), 4.2 g of PERBUTYL P (manufactured by NOF CORPORATION), and 43.2 g of mesitylene (manufactured by Tokyo Chemical Industry Co., Ltd.), and the mixture was stirred to prepare a solution -9. Separately, a 300 mL recovery flask was charged with 57.5 g of mesitylene (manufactured by Tokyo Chemical Industry Co., Ltd.) and heated in an oil bath at 100°C while stirring the component with a stirrer, and the solution -5 was added dropwise to the flask. After the dropwise addition, the solution was directly heated and stirred for 24 hours, and the recovered polymer solution was used as a release agent component 9.

### [Example 1] Preparation of Adhesive Composition

50.0 g of the adhesive component 1 prepared in Preparation Example 1 was used, 50.0 g of the release agent component 1 prepared in Preparation Example 2 and 0.5 g of 1,1-diphenyl-2-propion-1-ol (manufactured by Tokyo Chemical Industry Co., Ltd.) were added to the adhesive component 1, and the mixture was stirred with a stirrer for 5 minutes to form an adhesive composition (A).

Subsequently, the release agent component 1 was replaced with each of the release agent components 2 to 9, and an operation similar to the above-described operation was performed to form adhesive compositions (B) to (I). Further, whether or not suspension occurred in each of the adhesive compositions was visually confirmed.

### [Example 2] Production of Laminate

Each of the adhesive compositions (A) to (I) was applied to each 100 mm silicon wafer (thickness: 500 µm) as a device-side wafer with a spin coater, and heated on a hot plate at 90°C for 90 seconds to form 30 µm-thick adhesive composition layers (A) to (I). A 100 mm glass wafer (EAGLE-XG, manufactured by Corning Incorporated, thickness: 500 µm) was prepared as a carrier-side wafer (support), and bonding was performed in a vacuum bonding apparatus so as to sandwich the adhesive composition layers (A) to (I) to form a laminate. Thereafter, the device-side wafer was heated on a hot plate at 200°C for 10 minutes, and thus each of the adhesive composition layers was cured to form laminates (A) to (I).

### [Comparative Example 1] Preparation of Laminate (without Mixing Release Agent Component)

The adhesive composition 1 was applied to a 100 mm silicon wafer (thickness: 500 µm) as a device-side wafer with a spin coater, and heated on a hot plate at 90°C for 90 seconds to form a 30 µm-thick adhesive composition layer 1. A 100 mm glass wafer (EAGLE-XG, manufactured by Corning Incorporated, thickness: 500 µm) was prepared as a carrier-side wafer (support), and bonding was performed in a vacuum bonding apparatus so as to sandwich the adhesive composition layer 1 to form a laminate. Thereafter, the device-side wafer was heated on a hot plate at 200°C for 10 minutes, and thus the adhesive composition layer was cured to form a laminate (1).

### [Example 3] Laser Irradiation Test

The resultant laminates were irradiated with a laser from the side of the glass wafer using a laser irradiation device at an output of 300 mJ/cm², and it was confirmed whether the glass wafer could be released. After the laser irradiation, the glass wafer was lifted with tweezers, and the case where the glass wafer could be easily released was denoted as "○", and the case where the glass wafer could not be released was denoted as "×".

The results of the laminates are shown in Table 1 below.

**[Table 1]**

| Adhesive component | Release agent component | Adhesive composition (laminate) | Turbidity of release agent component | Result of laser irradiation test |
|---|---|---|---|---|
| 1 | not added | 1 | not observed | × |
| 1 | 1 | A | not observed | ○ |
| 1 | 2 | B | not observed | ○ |
| 1 | 3 | C | not observed | ○ |
| 1 | 4 | D | not observed | ○ |
| 1 | 5 | E | not observed | ○ |
| 1 | 6 | F | observed | ○ |
| 1 | 7 | G | observed | ○ |
| 1 | 8 | H | not observed | ○ |
| 1 | 9 | I | not observed | ○ |

In the laminates A to I to which the release agent component was added, release was possible after the laser irradiation. Meanwhile, in the laminate 1 to which the release agent component was not added, release was not possible.

Further, it was found that when the third unit was included in the release agent component, the turbidity of the release agent component could be effectively prevented.

### Reference Signs List

- 1: Semiconductor substrate
- 2: Adhesive layer
- 3: Support substrate

## Claims

1. An adhesive composition for release by light irradiation for forming an adhesive layer of a laminate including a semiconductor substrate, a support substrate, and the adhesive layer provided between the semiconductor substrate and the support substrate, and the laminate being used for releasing the semiconductor substrate and the support substrate each other after the adhesive layer absorbs light emitted from a side of the support substrate,
the adhesive composition comprising: an adhesive component (S); and a release agent component (R), wherein
the adhesive component (S) contains a polysiloxane resin, and
the release agent component (R) contains a (meth)acrylic polymer including a silicone-based first unit and a light-absorbing structured second unit.

2. The adhesive composition according to claim 1, wherein the silicone-based first unit is represented by any one of the following Formulae (A-1) and (A-2): 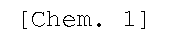 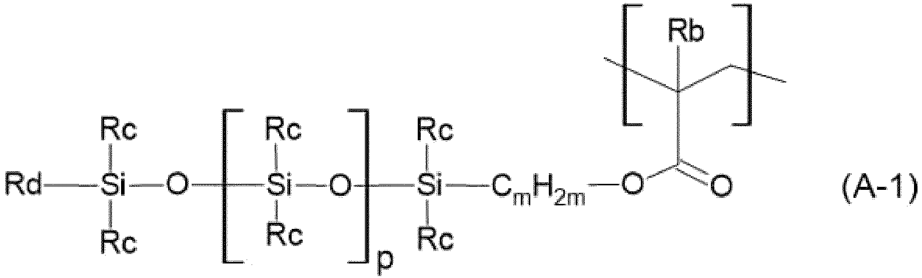 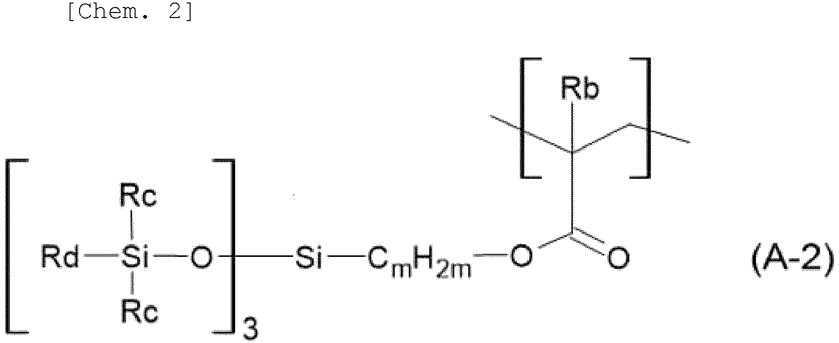 where Rb represents a hydrogen atom or a methyl group, Rc and Rd each independently represent a hydrogen atom, an alkyl group, or a phenyl group, and m and p each independently represent an integer of 0 or more.

3. The adhesive composition according to claim 1, wherein the light-absorbing structured second unit has a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, a phenylbenzotriazole structure, an acenaphthene structure, and a cinnamic acid-derived structure.

4. The adhesive composition according to claim 3, wherein the light-absorbing structured second unit has a structure represented by any one of the following Formulae (1) to (9): 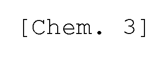 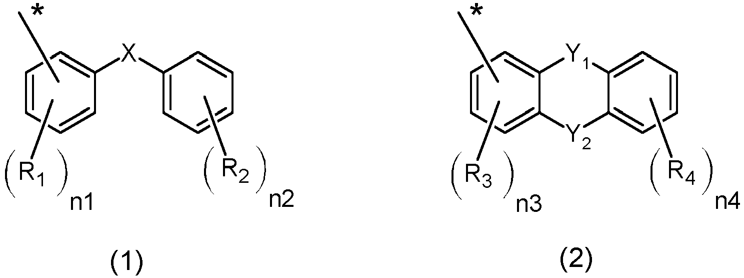 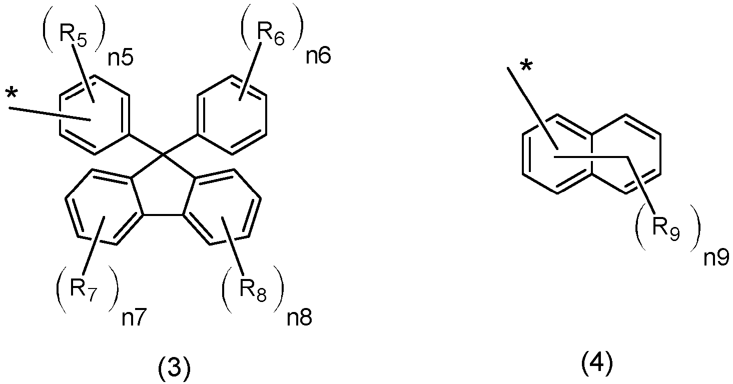 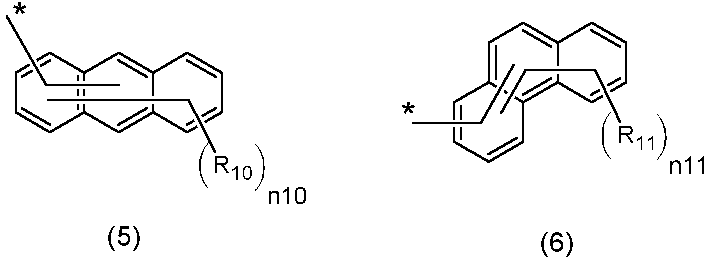 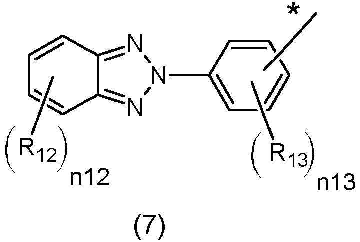 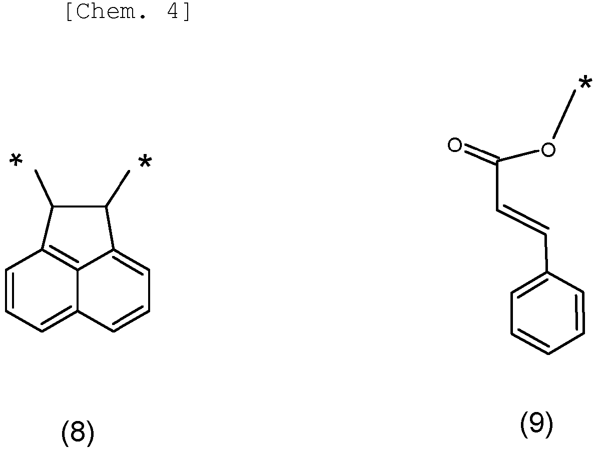
where R₁ to R₁₃ each independently represent a halogen atom or a monovalent group,
X represents a single bond, -O-, -CO-, -NR₃₁- (R₃₁ represents a hydrogen atom, an optionally substituted alkyl group, or an optionally substituted aryl group.), -SO-, - SO₂-, or -N=N-,
Y₁ represents a single bond or -CO-,
when Y₁ is a single bond, Y₂ represents -O-, -CO-, or - NR₃₂- (R₃₂ represents a hydrogen atom, an optionally substituted alkyl group, or an optionally substituted aryl group.),
when Y₁ is -CO-, Y₂ represents -CO-,
n1 is an integer of 0 to 4,
n2 is an integer of 0 to 5,
n3 is an integer of 0 to 3,
n4 is an integer of 0 to 4,
n5 is an integer of 0 to 4,
n6 is an integer of 0 to 5,
n7 is an integer of 0 to 4,
n8 is an integer of 0 to 4,
n9 is an integer of 0 to 7,
n10 is an integer of 0 to 9,
n11 is an integer of 0 to 9,
n12 is an integer of 0 to 4,
n13 is an integer of 0 to 4,
each asterisk * represents a bonding hand, and
when a plurality of R₁ to R₁₃ is present, each of the plurality of R₁ to R₁₃ may be identical to or different from one another.

5. The adhesive composition according to claim 4, wherein the light-absorbing structured second unit is represented by any one of the following Formulae (B-1) to (B-5):

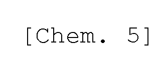

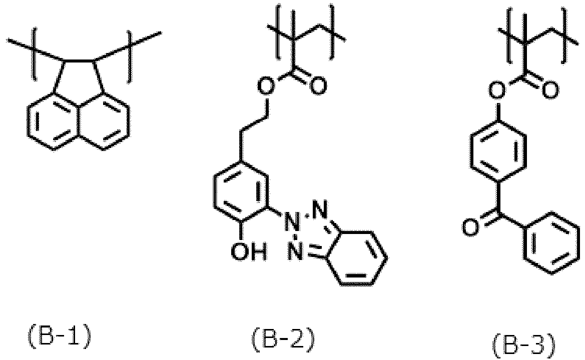

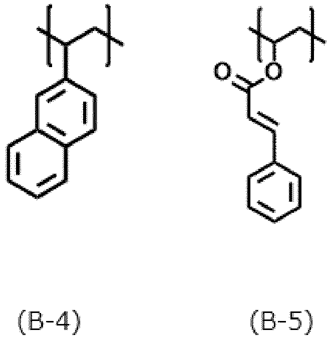

6. The adhesive composition according to claim 1, wherein the polysiloxane resin contained in the adhesive component (S) contains a component (A) that is cured.

7. The adhesive composition according to claim 6, wherein the component (A) that is cured is a component that is cured by a hydrosilylation reaction.

8. The adhesive composition according to claim 7, wherein the component (A) that is cured contains:
a polyorganosiloxane (a1) containing an alkenyl group having 2 to 40 carbon atoms bonded to a silicon atom;
a polyorganosiloxane (a2) containing a Si-H group; and
a platinum group metal-based catalyst (A2).

9. The adhesive composition according to claim 1, wherein the (meth)acrylic polymer contained in the release agent component (R) further contains a third unit represented by the following Formula (C-1) or (C-2): 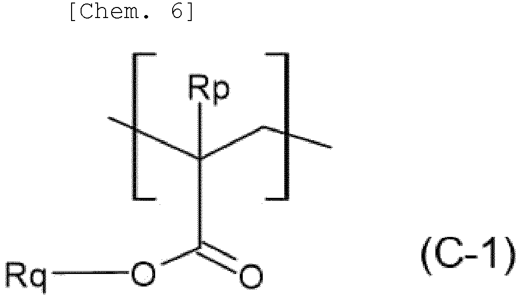 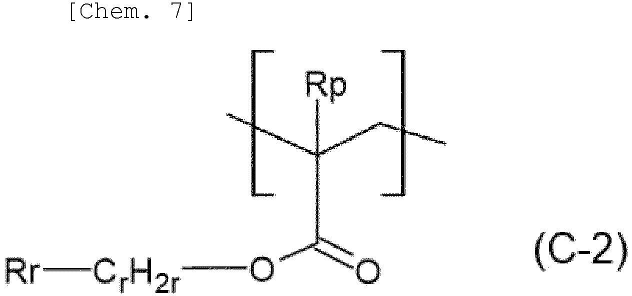 where Rp represents a hydrogen atom or a methyl group, Rq represents a chain saturated hydrocarbon group having 3 or more carbon atoms, Rr represents an aromatic hydrocarbon group or an aliphatic hydrocarbon group having 6 or more carbon atoms, and r represents an integer of 0 or more.

10. The adhesive composition according to claim 9, wherein the third unit is represented by any one of the following Formulae (C-3) to (C-7):

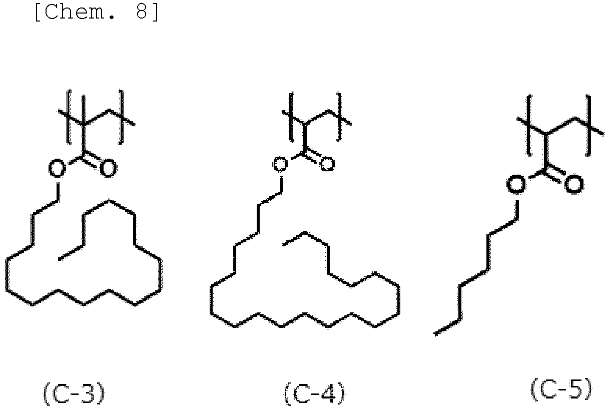

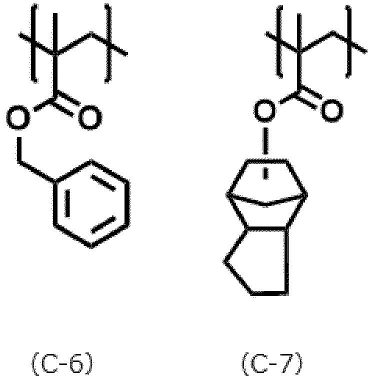

11. A laminate comprising:
a semiconductor substrate;
a light-transmissive support substrate; and
an adhesive layer provided between the semiconductor substrate and the support substrate,
the laminate being used for releasing the semiconductor substrate and the support substrate each other after the adhesive layer absorbs light emitted from a side of the support substrate,
wherein the adhesive layer is formed of the adhesive composition according to any one of claims 1 to 10.

12. A method for producing a processed semiconductor substrate,
the method comprising:
a third step of processing the semiconductor substrate of the laminate according to claim 11; and
a fourth step of separating the semiconductor substrate, which has been processed in the third step, and the support substrate from each other.

13. The method for producing a processed semiconductor substrate according to claim 12, wherein the fourth step includes a step of irradiating the laminate with a laser from a side of the support substrate.
